Europäisches Patentamt

European Patent Office

Office européen des brevets

(19)

(11) Numéro de publication: **0 195 700**
**B1**

(12) **FASCICULE DE BREVET EUROPEEN**

(45) Date de publication du fascicule du brevet:
**23.05.90**

(51) Int. Cl.⁵: **H01L 23/52, H01L 21/90**

(21) Numéro de dépôt: **86400402.3**

(22) Date de dépôt: **25.02.86**

(54) **Procédé de formation sur un substrat d'une couche de siliciure de métal réfractaire éventuellement recouverte d'isolant, utilisable notamment pour la réalisation de couches d'interconnexion des circuits intégrés.**

(30) Priorité: **01.03.85 FR 8503042**

(43) Date de publication de la demande:
**24.09.86 Bulletin 86/39**

(45) Mention de la délivrance du brevet:
**23.05.90 Bulletin 90/21**

(84) Etats contractants désignés:
**AT BE CH DE FR GB IT LI LU NL SE**

(56) Documents cités:
**EP-A- 0 055 161**
**DE-A- 3 027 954**
**FR-A- 2 491 260**
**US-A- 3 771 026**
**US-A- 4 265 935**

(73) Titulaire: **CENTRE NATIONAL DE LA RECHERCHE SCIENTIFIQUE (CNRS), 15, Quai Anatole France, F-75700 Paris Cedex 07(FR)**

(72) Inventeur: **Deneuville, Alain, 12, rue du Fournet, F-38120 Saint Egreve(FR)**
Inventeur: **Mandeville, Pierre, 4738 Parthenais, Montreal H2H267(CA)**

(74) Mandataire: **Mongrédien, André et al, c/o BREVATOME 25, rue de Ponthieu, F-75008 Paris(FR)**

ACTORUM AG

## Description

La présente invention a pour objet un procédé de formation d'une couche de siliciure de métal réfractaire. Elle s'applique en particulier aux métaux réfractaires ayant un point de fusion supérieur à 1400°C, par exemple aux métaux des groupes IVa, Va et VIa de la classification périodique des éléments, tels que Ti, Zr, Hf, V, Nb, Ta, Cr, Mo et W.

De façon plus précise, elle concerne la réalisation de couches d'interconnexion pour la fabrication de circuits intégrés.

Dans les domaines de la microélectronique et plus particulièrement celui des circuits intégrés au silicium utilisant des transistors MOS ou bipolaires, il est nécessaire de relier ces dispositifs élémentaires entre eux ainsi qu'aux autres composants du circuit et aux alimentations extérieures, ce qui est effectué au moyen de couches minces conductrices appelées couches d'interconnexion.

Jusqu'à présent, ces couches d'interconnexion ont été réalisées en aluminium, qui présente la propriété d'être très conducteur, mais a l'inconvénient de réagir avec le silicium, même lorsque celui-ci est sous la forme de $SiO_2$ pour former des alliages aluminium-silicium.

Avec les problèmes de miniaturisation des circuits, les tailles latérales des composants ont diminué pour permettre la mise en place d'un nombre plus important de composants sur un même circuit. De ce fait, l'épaisseur des différentes couches a diminué et les problèmes de réaction des couches d'interconnexion avec le silicium sont devenus importants.

Afin d'éviter ces interactions, on a intercalé entre l'aluminium et les composés contenant du silicium des couches servant de barrières de diffusion réalisées par exemple en chrome ou en tungstène.

Pour avoir un meilleur alignement de la source et du drain des transistors MOS, on a aussi utilisé des grilles de silicium polycristallin fortement dopé pour faire de l'auto-alignement. Ainsi, on a remplacé progressivement l'aluminium par du silicium polycristallin fortement dopé, mais celui-ci a l'inconvénient de ne pas être assez conducteur.

Aussi, les recherches actuelles se sont orientées vers l'emploi de nouveaux matériaux tels que les siliciures de métaux réfractaires pour la réalisation des couches d'interconnexion et pour shunter le silicium polycristallin de grille. En effet, les siliciures de métaux réfractaires sont intéressants car ils sont stables aux températures élevées utilisées lors des traitements thermiques de fabrication des circuits intégrés et ils présentent une conductivité électrique élevée. Ces siliciures peuvent être formés à haute température par croissance thermique à partir d'une couche métallique déposée sur du silicium polycristallin, mais l'emploi de températures élevées est néfaste car elles font évoluer les caractéristiques physico-chimiques et électroniques des autres couches et des composants déjà formés sur le circuit intégré.

On peut aussi former de tels films de siliciure par coévaporation des deux éléments, silicium et tungstène par exemple, sous vide poussé ($10^{-7}$ Torr) suivie d'un traitement de recuit à 1000°C sous atmosphère d'hydrogène, comme il est décrit dans Appl. Phys. Lett. 33(1) 1978, p.76-78. Cependant, ce procédé présente des problèmes de mise en oeuvre notamment pour obtenir le vide poussé nécessaire au dépôt.

On peut encore former de tels films en soumettant à une implantation ionique de As$^+$ à chaud suivie d'un traitement de recuit un film mince du métal réfractaire déposé sous ultra-vide sur un substrat en silicium, comme il est décrit dans Appl. Phys. Lett. 37(3) 1980, p.295-298. Ce procédé présente également l'inconvénient de nécessiter l'emploi de vides poussés, par ailleurs les courants d'implantation doivent être élevés (1,5 µA.cm$^{-2}$) et il est nécessaire de chauffer simultanément (350°C) pour obtenir la couche de siliciure.

Des essais de fabrication des siliciures réfractaires à plus basses températures n'ont pas abouti jusqu'à présent en raison du fait que la formation du siliciure est bloquée par la présence de traces d'oxygène comme il est indiqué par D.J. Silversmith, D.D Rathman and R.W. Mountain dans "Thin Solid Films", 93. 413, 1982.

La présente invention a précisément pour objet un procédé de formation sur un substrat d'une couche de siliciure de métal réfractaire, qui ne nécessite pas l'emploi de températures élevées et qui peut être mis en oeuvre facilement à l'échelle industrielle.

Le procédé selon l'invention de formation sur un substrat d'une couche de siliciure de métal réfractaire, se caractérise en ce qu'il comprend les étapes successives suivantes :

a) - déposer sur ledit substrat une première couche de silicium amorphe hydrogéné,

b) - déposer sur ladite première couche une deuxième couche de métal réfractaire amorphe hydrogéné,

c) - déposer sur ladite deuxième couche une troisième couche de silicium amorphe hydrogéné, et

d) - soumettre le substrat revêtu ainsi obtenu à un traitement de recuit effectué à une température supérieure ou égale à 350°C en atmosphère d'hydrogène.

Comme on l'a indiqué précédemment le métal réfractaire est un métal ayant un point de fusion supérieur à 1400°C, par exemple un métal des groupes IVa, Va ou VIa. On utilise de préférence le tungstène, le tantale, le titane ou le molybdène.

L'utilisation, selon le procédé de l'invention, de deux couches de silicium amorphe hydrogéné entre lesquelles est disposée une couche de métal réfractaire amorphe hydrogéné, permet d'éviter les problèmes de formation du siliciure liés à la présence de traces d'oxygène. En effet, pour déposer les couches hydrogénées, il est nécessaire d'opérer en présence d'hydrogène, ce qui rend le milieu de dépôt très réducteur et permet de saturer d'hydrogène la surface libre des couches de silicium et de métal réfractaire, ce qui empêche la formation d'un oxyde natif au contact de l'air, la présence d'oxygène inhibant la formation du siliciure de métal réfractaire. De ce fait, il n'est pas nécessaire de maintenir le substrat sous vide entre chaque opération de dépôt, ce qui facilite la mise en oeuvre du procédé.

Par ailleurs, le fait d'utiliser du métal réfractaire M amorphe, à structure plus ouverte, donc à liaisons M-M plus faibles, contenant de plus des défauts de structure, permet de faciliter la diffusion du silicium dans le métal réfractaire lors du traitement thermique de recuit conduisant à la formation du siliciure de métal réfractaire.

De même, l'utilisation de silicium amorphe avec des liaisons Si-Si plus faibles, facilite au départ la séparation des atomes de silicium qui vont diffuser vers le métal réfractaire.

Selon un mode préféré de mise en oeuvre du procédé de l'invention, on réalise une étape complémentaire consistant à soumettre au moins certaines zones du substrat revêtu des trois couches à une implantation ionique, avant de réaliser l'étape d) de recuit. Les ions utilisés pour cette implantation peuvent être des ions de métal réfractaire, des ions de silicium ou des ions d'un élément ne réagissant ni avec le métal réfractaire, ni avec le silicium, par exemple de xénon, de krypton.

Cette implantation permet de créer des défauts supplémentaires dans les couches de silicium amorphe hydrogéné et dans la couche de métal réfractaire amorphe hydrogéné, ce qui permet d'obtenir une vitesse de diffusion des atomes de silicium et des atomes de métal, beaucoup plus importante et de former ainsi beaucoup plus rapidement la couche de siliciure de métal réfractaire.

De plus, on peut réaliser l'implantation ionique seulement sur certaines zones du substrat, ce qui permet de former la couche de siliciure seulement sur les zones du substrat, qui ont été soumises à l'implantation. Ceci présente un grand intérêt pour la réalisation des couches d'interconnexion des circuits intégrés, car on peut ainsi éviter l'étape finale de gravure du siliciure de métal réfractaire qui pose certains problèmes de réalisation.

En effet, grâce à cette implantation, lors de l'étape suivante de recuit, le siliciure, par exemple le siliciure de tungstène, se forme beaucoup plus rapidement sur les zones implantées que sur les zones non implantées, la vitesse de formation du siliciure de tungstène sur les zones implantées étant environ 50 à 100 fois plus importante. De ce fait, en choisissant la durée du traitement de recuit de façon appropriée, on peut former la couche de siliciure de tungstène uniquement sur les zones implantées. Après cette opération, on élimine par des procédés classiques les couches déposées sur les zones non soumises à l'implantation ionique, qui sont constituées pratiquement par du silicium et du tungstène beaucoup plus faciles à éliminer que le siliciure de tungstène.

Pour le dépôt des différentes couches, on utilise avantageusement la pulvérisation cathodique réactive.

Ainsi, la première couche de silicium amorphe hydrogéné peut être déposée par pulvérisation cathodique réactive d'une cible de silicium en présence d'hydrogène en utilisant par exemple un mélange gazeux formé d'hydrogène et d'un gaz inerte tel que l'argon, la proportion d'hydrogène dans le mélange pouvant aller jusqu'à 40 %.

Généralement, on opère à une température de 30 à 350°C en utilisant un appareillage de pulvérisation cathodique à diode radiofréquence, et l'on choisit les conditions de dépôt de façon à obtenir une vitesse de dépôt supérieure à 2 nm par minute. On peut aussi réaliser cette pulvérisation cathodique au moyen de dispositifs à magnétron, ce qui permet d'opérer avec des vitesses de formation plus élevées.

Il est également possible d'obtenir le dépôt de la couche de silicium amorphe hydrogéné par décomposition d'un silane présent dans un mélange gazeux de silane et d'hydrogène par décharge luminescente. Les mélanges gazeux utilisés contiennent généralement de 10 à 100% de silane tel que du $SiH_4$ et l'on opère de préférence à une température de 30 à 350°C.

Le dépôt de la troisième couche de silicium amorphe hydrogéné peut être réalisé de la même façon que celui de la première couche, par exemple par pulvérisation cathodique réactive en utilisant un mélange d'argon et d'hydrogène, mais de préférence à une température inférieure, par exemple à la température ambiante, en choisissant les conditions de dépôt pour avoir une faible vitesse de dépôt.

La deuxième couche de métal réfractaire hydrogéné peut être aussi déposée par pulvérisation cathodique réactive en présence d'hydrogène, en utilisant un mélange gazeux d'hydrogène et d'un gaz rare tel que l'argon, contenant jusqu'à 40% d'hydrogène. On opère de préférence à la température ambiante et on choisit les conditions de dépôt pour obtenir une vitesse de dépôt très faible, par exemple de l'ordre de 1,5 mm par minute. On pourrait aussi former cette couche de métal réfractaire hydrogéné en utilisant d'autres procédés, par exemple l'évaporation réactive, la décomposition thermique ou assistée par plasma d'un gaz ou d'un mélange de gaz contenant le métal réfractaire et de l'hydrogène.

Pour la mise en oeuvre du procédé de l'invention, la température utilisée pour le traitement de recuit est choisie notamment en fonction de la nature du métal réfractaire utilisé.

En effet, la température doit être suffisante pour que l'on obtienne une recristallisation de la couche de siliciure avec augmentation de la taille des cristallites et diminution du désordre résiduel dans chaque cristallite. Par ailleurs, elle est de préférence telle que l'on obtienne lors du traitement de recuit, une ségrégation vers la surface externe de la couche de siliciure de métal réfractaire du $SiO_2$ formé à partir de l'oxygène résiduel présent dans les couches de métal réfractaire et/ou de silicium, et/ou à l'interface de ces couches. Ceci conduit à la formation d'une couche isolante de $SiO_2$ qui recouvre la surface externe de la couche de siliciure du métal réfractaire. Pour obtenir ce résultat, il est nécessaire d'opérer à des températures et pendant des durées suffisantes qui dépendent de la nature du métal réfractaire utilisé, en particulier de son affinité pour l'oxygène, et de la quantité d'oxygène résiduel présent dans les couches.

Lorsque le métal réfractaire est le tungstène, on utilise une température supérieure ou égale à 550°C pour former la couche de siliciure de tungstène revêtue d'une couche isolante de $SiO_2$ par exemple une température de 650°C pendant 10h ou une température de 750°C pendant 1 heure.

Lorsque le métal réfractaire est le tantale qui a une affinité plus importante pour l'oxygène, on peut utiliser des températures inférieures, par exemple des températures supérieures ou égales à 400°C pour former la couche de siliciure de tantale revêtue d'une couche isolante de $SiO_2$

Cette formation simultanée d'une couche de $SiO_2$ sur la couche de siliciure de métal réfractaire présente un grand intérêt, notamment lorsque la couche de siliciure de métal réfractaire est destinée à servir de couche d'interconnexion dans un circuit intégré. En effet, les circuits intégrés deviennent de plus en plus complexes et il est souvent nécessaire de former dans ces circuits plusieurs niveaux d'interconnexion. Dans ce cas, il faut les isoler entre eux et donc former une couche d'isolant sur chaque couche d'interconnexion. Grâce au procédé de l'invention, ceci peut être réalisé en même temps que le dépôt de la couche d'interconnexion, ce qui n'est pas le cas avec les procédés de l'art antérieur.

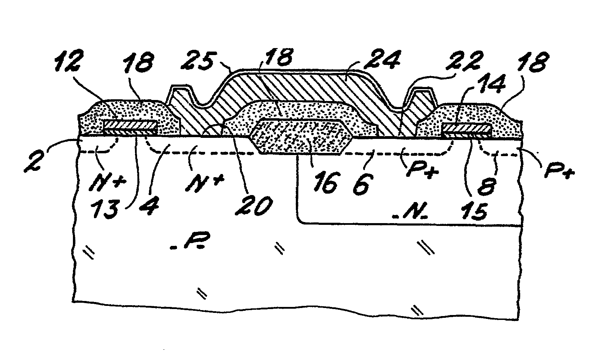

D'autres caractéristiques et avantages de l'invention apparaîtront mieux à la lecture de la description qui suit d'un exemple de mise en oeuvre du procédé de l'invention, donné bien entendu à titre illustratif et non limitatif en référence au dessin unique annexé qui représente un circuit intégré CMOS.

Sur cette figure, on a représenté en coupe longitudinale un inverseur CMOS permettant d'illustrer la mise en place d'une couche de connexion entre les zones actives du circuit.

Après avoir réalisé les éléments constitutifs du circuit intégré, c'est-à-dire les zones actives telles que les sources 2 et 8 et les drains 4 et 6 des transistors du circuit, les grilles 12 et 14 de ces transistors, les oxydes de grille 13 et 15 correspondants et l'oxyde de champ 16, on dépose sur l'ensemble du circuit intégré une couche d'isolant 18 généralement en oxyde de silicium, puis on grave cette couche d'isolant afin de réaliser les trous de contact électrique tels que 20 et 22 des zones actives ainsi que ceux des grilles. Ensuite, on dépose sur la couche d'isolant gravée 18 une couche conductrice et on réalise les connexions voulues telles que la connexion 24 entre le drain 4 du transistor à canal N et le drain 6 du transistor à canal P de l'inverseur et l'on recouvre éventuellement cette connexion 24 d'une couche isolante 25.

Pour réaliser cette connexion 24 revêtue d'isolant 25, on utilise le procédé de l'invention.

Dans ce but, on dépose tout d'abord sur l'ensemble du substrat (couche d'oxyde gravée 18) une première couche de silicium amorphe hydrogéné par pulvérisation cathodique réactive d'une cible de silicium, en utilisant un dispositif de pulvérisation cathodique à diode radiofréquence et un mélange gazeux comportant 20% d'hydrogène et 80% d'argon et en opérant dans les conditions suivantes :
- température : 200°C,

- puissance du faisceau excitateur : 1,25 W/cm²
- vitesse de dépôt : 13 nm/min
- durée : 4 min
- pression : $8.10^{-3}$ Torr (1,064 Pa)

On obtient ainsi une couche de silicium amorphe hydrogéné de 52 nm d'épaisseur.

On dépose ensuite sur cette première couche de silicium amorphe hydrogéné une couche de tungstène amorphe hydrogéné par pulvérisation cathodique réactive d'une cible de tungstène, en utilisant un mélange gazeux comportant 20% d'hydrogène et 80% d'argon et en opérant dans les conditions suivantes :
- température : température ambiante,
- puissance du faisceau excitateur : 0,35 W/cm²
- vitesse de dépôt : 1,5 nm/min
- durée : 15 min
- pression : $1,8.10^{-2}$ Torr (2,398 Pa)

On obtient ainsi une couche de tungstène amorphe hydrogéné de 22,5 nm d'épaisseur.

Après cette opération, on dépose une troisième couche de silicium amorphe hydrogéné par pulvérisation cathodique d'une cible de silicium en utilisant un mélange gazeux comprenant 20% d'hydrogène et 80% d'argon et en opérant dans les conditions suivantes :
- température : température ambiante,
- puissance : 0,625 W/cm²
- vitesse de dépôt : 3 nm/min.
- durée : 15 min

On obtient ainsi une couche de silicium amorphe hydrogéné de 45 nm d'épaisseur.

Après ces différentes opérations, on soumet le substrat revêtu des trois couches à une implantation ionique uniquement sur les zones du substrat qui correspondent à la connexion 24 à réaliser, en utilisant des ions tungstène et les conditions d'implantation suivantes :
- température : ambiante
- durée : 4 heures
- dose d'implantation : $10^{16}$ atomes/cm²,
- énergie du faisceau : 190 keV
- courant d'implantation : 0,1 µA.cm⁻²

Ainsi, on crée des défauts dans les zones des trois couches soumises à l'implantation.

Après cette opération, on soumet le substrat à un traitement thermique de recuit sous atmosphère d'hydrogène à une température de 650°C pendant 10 heures.

On forme ainsi une couche de siliciure de tungstène de formule $WSi_2$ revêtue d'une couche de $SiO_2$ sur les zones du substrat qui correspondent à la connexion 24 à réaliser et cette connexion est revêtue simultanément de la couche isolante 25.

Dans ces conditions, sur les zones du substrat, qui n'ont pas été soumises à l'implantation, la couche de siliciure de tungstène n'a pas eu le temps de se former car la vitesse de diffusion entre les atomes de tungstène et de silicium est trop lente par rapport à la vitesse de diffusion de ces mêmes atomes dans les zones soumises à l'implantation.

Pour obtenir la connexion 24 recouverte de la couche 25, il suffit alors d'éliminer le tungstène et le silicium sur les zones du substrat qui n'ont pas été soumises à l'implantation et ceci peut être effectué par gravure humide HF-NO₃H pour éliminer Si et puis HCl-NO₃H pour éliminer W.

La couche de siliciure de tungstène ainsi obtenue de formule WSi₂ présente une épaisseur d'environ 650 Å et une résistivité de l'ordre de 100 μ Ω .cm.

Dans un autre exemple de réalisation, on dépose la première couche de silicium amorphe hydrogéné par décomposition de silane à partir d'un mélange comportant 10% SiH₄ et 90% d'hydrogène par décharge luminescente à 50 kHz à 300°C avec une vitesse de dépôt de l'ordre de 13,3 nm/min pendant une durée de 4 min, ce qui permet d'obtenir une couche de silicium amorphe hydrogéné de 54 nm d'épaisseur.

On réalise ensuite les opérations de dépôt de la couche de tungstène amorphe hydrogéné, de dépôt de la couche de silicium amorphe hydrogéné, d'implantation ionique et de recuit dans les mêmes conditions que celles décrites précédemment.

On obtient ainsi une couche de siliciure de tungstène WSi₂ recouverte d'une couche de SiO₂ sur les zones du substrat qui correspondent à la connexion 24, et celle-ci présente une épaisseur et une résistivité électrique équivalentes à celles obtenues en réalisant le dépôt de la première couche par pulvérisation cathodique réactive.

On constate ainsi que le procédé de l'invention est très avantageux pour la réalisation de couches d'interconnexion car il ne nécessite pas l'emploi de températures élevées qui pourraient nuire aux caractéristiques physico-chimiques et aux propriétés électroniques des composants déjà réalisés sur le substrat. Par ailleurs, il permet d'éviter les problèmes posés par la gravure d'une couche de siliciure de métal réfractaire. Sa mise en oeuvre est simple car on peut déposer les couches de silicium amorphe et de métal réfractaire amorphe par pulvérisation cathodique alors que les procédés de l'art antérieur nécessitaient des opérations de dépôt sous ultra-vide.

De plus, ce procédé permet la réalisation de multicouches d'interconnexion séparées par des couches d'isolant à base d'oxyde de silicium. En effet, on peut obtenir le dépôt de la couche d'oxyde isolant en même temps et la présence d'oxygène inhibe la formation du siliciure, ce qui garantit l'isolation entre les couches de siliciure métallique, même avec des épaisseurs très faibles d'isolant.

**Revendications**

1. Procédé de formation sur un substrat d'une couche de siliciure de métal réfractaire, caractérisé en ce qu'il comprend les étapes successives suivantes :
   a) - déposer sur ledit substrat une première couche de silicium amorphe hydrogéné,
   b) - déposer sur ladite première couche une deuxième couche de métal réfractaire amorphe hydrogéné,
   c) - déposer sur ladite deuxième couche une troisième couche de silicium amorphe hydrogéné, et
   d) - soumettre le substrat revêtu ainsi obtenu à un traitement de recuit effectué à une température supérieure ou égale à 350°C en atmosphère d'hydrogène.

2. Procédé selon la revendication 1, caractérisé en ce que l'on soumet au moins certaines zones du substrat revêtu des trois couches à une implantation ionique en utilisant des ions choisis parmi les ions de métal réfractaire, de silicium et d'éléments ne réagissant ni avec le métal réfractaire ni avec le silicium, avant de réaliser l'étape d) de recuit.

3. Procédé selon la revendication 2, caractérisé en ce que les ions sont des ions de tungstène.

4. Procédé selon l'une quelconque des revendications 2 et 3, caractérisé en ce que l'implantation ionique est réalisée seulement sur certaines zones du substrat et en ce que l'on effectue le traitement thermique de recuit pendant une durée telle que l'on forme la couche de siliciure de métal réfractaire seulement sur les zones du substrat qui ont été soumises à l'implantation ionique.

5. Procédé selon l'une quelconque des revendications 1 et 2, caractérisé en ce que le métal réfractaire est choisi parmi le tungstène, le tantale, le titane, et le molybdène.

6. Procédé selon l'une quelconque des revendications 1 et 2, caractérisé en ce que le métal réfractaire étant le tungstène, le traitement de recuit est effectué à une température supérieure ou égale à 550°C.

7. Procédé selon l'une quelconque des revendications 2 et 5, caractérisé en ce que la température du traitement de recuit est telle que l'on forme une couche de siliciure de métal réfractaire revêtue d'une couche isolante de SiO₂

8. Procédé selon la revendication 1, caractérisé en ce que la première et la troisième couches de silicium amorphe hydrogéné sont déposées par pulvérisation cathodique réactive en présence d'hydrogène.

9. Procédé selon la revendication 8, caractérisé en ce que la première couche est déposée à une température de 30 à 350°C.

10. Procédé selon la revendication 8, caractérisé en ce que la troisième couche est déposée à la température ambiante.

11. Procédé selon la revendication 1, caractérisé en ce que la première couche de silicium amorphe hydrogéné est formée par décomposition d'un mélange gazeux contenant du silane et de l'hydrogène par décharge luminescente.

12. Procédé selon la revendication 11, caractérisé en ce que le mélange gazeux comprend de 10% à 100% de silane.

13. Procédé selon l'une quelconque des revendications 1 et 2, caractérisé en ce que la deuxième couche de métal réfractaire amorphe hydrogéné est déposée par pulvérisation cathodique réactive.

14. Utilisation du procédé selon l'une quelconque des revendications 1 à 13, pour la réalisation des couches d'interconnexion des circuits intégrés.

**Claims**

1. Process for the formation on a substrate of a refractory metal silicide layer, characterized in that it comprises the following successive stages:

a) depositing on said substrate a first hydrogenated amorphous silicon layer,

b) depositing on said first layer a second amorphous hydrogenated refractory metal layer,

c) depositing on said second layer a third hydrogenated amorphous silicon layer and,

d) subjecting the thus obtained coated substrate to an annealing treatment at a temperature equal to or higher than 350°C in a hydrogen atmosphere.

2. Process according to claim 1, characterized in that at least certain zones of the substrate covered with the three layers undergo ionic implantation using ions chosen from among the ions of refractory metal, silicon and elements not reacting either with the refractory metal or with the silicon, prior to carrying out annealing stage d).

3. Process according to claim 2, characterized in that the ions are tungsten ions.

4. Process according to either of the claims 2 and 3, characterized in that ionic implantation is carried out solely over certain zones of the substrate and wherein the thermal annealing treatment is carried out for a time such that the refractory metal silicide layer is only formed on the substrate zones not subjected to ionic implantation.

5. Process according to either of the claims 1 and 2, characterized in that the refractory metal is chosen from among tungsten, tantalum, titanium and molybdenum.

6. Process according to either of the claims 1 and 2, characterized in that the refractory metal is tungsten, so that the annealing treatment is performed at a temperature equal to or higher than 550°C.

7. Process according to either of the claims 2 and 5, characterized in that the annealing treatment temperature is such that a refractory metal silicide layer coated with an isolating $SiO_2$ layer is formed.

8. Process according to claim 1, characterized in that the first and third amorphous hydrogenated silicon layers are deposited by reactive cathodic sputtering in the presence of hydrogen.

9. Process according to claim 8, characterized in that the first layer is deposited at a temperature between 30 and 350°C.

10. Process according to claim 8, characterized in that the third layer is deposited at ambient temperature.

11. Process according to claim 1, characterized in that the first amorphous hydrogenated silicon layer is formed by the decomposition of a gaseous mixture containing silane and hydrogen by glow discharge.

12. Process according to claim 11, characterized in that the gaseous mixture contains 10 to 100% silane.

13. Process according to either of the claims 1 and 2, characterized in that the second amorphous hydrogenated refractory metal layer is deposited by reactive cathodic sputtering.

14. Use of the process according to any one of the claims 1 to 13 for producing the interconnection layers of integrated circuits.

## Patentansprüche

1. Verfahren zur Erzeugung einer Schicht aus einem feuerfesten Metallsilicid auf einem Substrat, dadurch gekennzeichnet, daß es die folgenden aufeinanderfolgenden Stufen umfaßt:

(a) Abscheidung einer ersten Schicht aus amorphem hydriertem Silicium auf dem Substrat,

(b) Abscheidung einer zweiten Schicht aus einem hydrierten amorphen feuerfesten Metall auf der ersten Schicht,

(c) Abscheidung einer dritten Schicht aus hydriertem amorphem Silicium auf der zweiten Schicht und

(d) Durchführung einer Glühbehandlung mit dem dabei erhaltenen beschichteten Substrat bei einer Temperatur von 350°C oder höher in einer Wasserstoffatmosphäre.

2. Verfahren nach Anspruch 1, dadurch gekennzeichnet, daß man vor Durchführung der Brennbehandlung in der Stufe (d) mindestens bestimmte Zonen des mit drei Schichten überzogenen Substrats einer Ionenimplantation unterwirft unter Verwendung von Ionen, die ausgewählt werden aus feuerfesten Metallionen, Siliciumionen und Ionen von Elementen, die weder mit dem feuerfesten Metall noch mit dem Silicium reagieren.

3. Verfahren nach Anspruch 2, dadurch gekennzeichnet, daß es sich bei den Ionen um Wolframionen handelt.

4. Verfahren nach einem der Ansprüche 2 und 3, dadurch gekennzeichnet, daß die Ionenimplantation nur für bestimmte Zonen des Substrats durchgeführt wird und daß man die thermische Glühbehandlung für eine solche Zeitdauer durchführt, daß sich die Schicht aus dem feuerfesten Metallsilicid nur auf den Zonen des Substrats bildet, die der Ionenimplantation unterworfen worden sind.

5. Verfahren nach einem der Ansprüche 1 und 2, dadurch gekennzeichnet, daß das feuerfeste Metall ausgewählt wird aus der Gruppe Wolfram, Tantal, Titan und Molybdän.

6. Verfahren nach einem der Ansprüche 1 und 2, dadurch gekennzeichnet, daß es sich bei dem feuerfesten Metall um Wolfram handelt und daß die Glühbehandlung bei einer Temperatur von 550°C oder höher durchgeführt wird.

7. Verfahren nach einem der Ansprüche 2 und 5, dadurch gekennzeichnet, daß die Temperatur der Glühbehandlung so ist, daß eine Schicht aus dem feuerfesten Metallsilicid gebildet wird, die von einer isolierenden Schicht aus $SiO_2$ bedeckt ist.

8. Verfahren nach Anspruch 1, dadurch gekennzeichnet, daß die erste und die dritte Schicht aus hydriertem amorphem Silicium durch reaktive Kathodenzerstäubung in Gegenwart von Wasserstoff abgeschieden werden.

9. Verfahren nach Anspruch 8, dadurch gekennzeichnet, daß die erste Schicht bei einer Temperatur von 30 bis 350°C abgeschieden wird.

10. Verfahren nach Anspruch 8, dadurch gekennzeichnet, daß die dritte Schicht bei Umgebungstemperatur abgeschieden wird.

11. Verfahren nach Anspruch 1, dadurch gekennzeichnet, daß die erste Schicht aus hydriertem amorphem Silicium durch Zersetzung eines Silan und Wasserstoff enthaltenden Gasgemisches durch Glimmentladung gebildet wird.

12. Verfahren nach Anspruch 11, dadurch gekennzeichnet, daß das Gasgemisch 10 bis 100% Silan enthält.

13. Verfahren nach einem der Ansprüche 1 und 2, dadurch gekennzeichnet, daß die zweite Schicht aus hydriertem amorphem feuerfestem Metall durch reaktive Kathodenzerstäubung abgeschieden wird.

14. Anwendung des Verfahrens nach einem der Ansprüche 1 bis 13 zur Herstellung von Verbindungsschichten integrierter Schaltungen.